# DEMANDE DE BREVET EUROPEEN

(11) **EP 4 769 401 A1**
(43) Date de publication de la demande: **01.07.2026**
(21) Numéro de dépôt: 25226406.4
(22) Date de dépôt: 22.12.2025
(51) Int. Cl.: G11C 5/04, H10W 70/40, H10W 74/01, H05K 7/14, H10W 72/00, H10W 72/60, H10W 90/00

(54) **INTERCONNECTEUR POUR MODULE DE PUISSANCE**

(30) Priorité: 29.12.2024 FR 2415359
(71) Demandeur: Valeo eAutomotive Germany GmbH, 91056 Erlangen (DE)
(72) Inventeur: VERCAMBRE, Virginie, 94000 CRETEIL (FR); MASSOL, Laurent, 94460 VALENTON (FR); DUGUE, Christophe, 94460 VALENTON (FR); PIERRE, Thomas, 94460 VALENTON (FR); KOPP, Gabriel, 94460 VALENTON (FR)
(74) Mandataire: Valeo Powertrain Systems

(57) **Abrégé**

L'invention concerne un interconnecteur (50) destiné à être électriquement connecté à un module de puissance (1) et à une carte électronique, caractérisé en ce qu'il comprend :
- une grille de connexion comprenant des éléments électriquement conducteurs (102, 202) parmi lesquels au moins une piste électriquement conductrice (102) de signal et au moins un conducteur (202) de puissance, chacun des éléments conducteurs comprenant, à une première extrémité, une plage de connexion (1023) destinée à être électriquement connectée au module de puissance (1) et, à une deuxième extrémité, une borne de connexion (2023)
- une enveloppe (51) partiellement surmoulée autour des éléments électriquement conducteurs (102, 202), les plage de connexion (1023) et les bornes de connexion (2023) étant disposées à l'extérieur de l'enveloppe (51).

## Description

La présente invention concerne le domaine de l'électronique de puissance et notamment le domaine des équipements d'alimentation de moteur électrique. La présente invention concerne plus particulièrement un interconnecteur pour module de puissance, un ensemble de puissance comprenant le module de puissance et son interconnecteur associé ainsi qu'un convertisseur de courant.

L'invention peut trouver son application, par exemple, dans les systèmes électroniques pour onduleurs de traction, pour chargeurs embarqués, pour pompes électriques de refroidissement, par exemple, de batterie, pour pompes à chaleur, pour capteurs laser, par exemple pour conduite autonome, etc...

Les modules électroniques comportent généralement des contacts permettant de connecter une carte électronique annexe comme une carte de commande d'un onduleur. Ces contacts permettent la transmission de signaux, par exemple, de commande entre le module de puissance et la carte électronique annexe.

Un module de puissance comprend typiquement une carte de puissance et des pistes électriquement conductrices, au moins une carte de signal. L'ensemble des pistes électriquement conductrices forme la grille de connexion, aussi connue sous sa dénomination anglo-saxonne « leadframe ». La grille de connexion forme les contacts vers l'extérieur du module et assure la connexion avec différents éléments du module de puissance comme expliqué ci-dessous.

La carte de puissance comprend des portions de puissance qui sont des bandes planes aménagées sur le substrat de la parte de puissance. Ces portions de puissance sont soit au potentiel B-, soit au potentiel B+, soit au potentiel Phase. La carte de puissance comprend également au moins un transistor de puissance. Les transistors de puissance permettent la conversion du courant continu et en un système de courant polyphasé et inversement. Il peut s'agir, par exemple, d'un transistor à effet de champ à grille isolée ou MOSFET pour Metal-Oxide-Semiconductor Field-Effect Transistor selon la terminologie anglo-saxonne.

Chaque portion de puissance est connectée électriquement à au moins une piste électriquement conductrice. Ainsi, chaque portion de puissance est connectée électriquement à la grille de connexion.

Enfin, un tel module de puissance de l'art antérieur comprend un boîtier enrobant la carte de puissance, la carte de signal et la grille de connexion.

Dans les modules électroniques de l'art antérieur, les transistors sont disposés sur la carte de puissance avec un espacement prédéfini pour éviter tout couplage thermique. Pour répondre à des contraintes d'encombrement, il est connu de disposer la grille de connexion au-dessus des cartes de puissance et de signal. Des piliers rigides de connexion électrique relient les transistors à la grille de connexion. On parle de module de puissance à plusieurs étages. La grille de connexion est soudée par laser aux piliers rigides.

Un tel arrangement présente certains inconvénients. D'une part, les piliers rigides soumis à des contraintes mécaniques peuvent entraîner l'endommagement des transistors. D'autre part, lors du soudage de la grille de connexion aux piliers, il y a un risque de projections métalliques sur les cartes de puissance et de signal, difficilement compatible d'une production de masse. De plus, afin de connecter les éléments du module entre eux, les possibilités de positionnement des différents chemins de signaux sont limitées ce qui peut s'avérer problématique selon les besoins de broches dans le module. L'architecture des modules de puissance de l'art antérieur sont de grande taille et à assemblage complexe. En outre, les modules de puissance connus offrent une adaptabilité d'intégration limitée pour les bornes de connexion des terminaux de puissance et de signal du module.

L'invention s'inscrit dans ce contexte et se base sur une séparation de la grille de connexion du module de puissance. L'invention propose un interconnecteur intégrant la grille de connexion de puissance et de signal sous forme d'une pièce surmoulée. Un tel interconnecteur permet une connexion aisée à son module de puissance associé et s'adapte facilement aux dispositions des broches de connexion de l'interface client.

Il en résulte un module de puissance de conception standard avec une connexion à la grille de connexion déportée conduisant à un module de puissance compact et directement applicable à différents systèmes électroniques, par exemple pour onduleurs de traction. En outre l'adaptation aux interfaces client est simplifiée.

A cet effet, l'invention concerne un interconnecteur destiné à être électriquement connecté à un module de puissance et à une carte électronique et/ou à des conducteurs de puissance, caractérisé en ce qu'il comprend :
- une grille de connexion comprenant des éléments électriquement conducteurs parmi lesquels au moins une piste électriquement conductrice de signal et au moins un conducteur de puissance, chacun des éléments conducteurs comprenant, à une première extrémité, une plage de connexion destinée à être électriquement connectée au module de puissance et, à une deuxième extrémité, une borne de connexion destinée à être électriquement connectée à la carte électronique et/ou aux conducteurs de puissance,
- une enveloppe partiellement surmoulée autour des éléments électriquement conducteurs, les plage de connexion et les bornes de connexion étant disposées à l'extérieur de l'enveloppe.

L'enveloppe peut être en thermoplastique. Elle surmoule partiellement les éléments électriquement conducteurs dans le sens où ces derniers ont leurs extrémités libres, c'est-à-dire directement accessibles. En d'autres termes les extrémités des éléments électriquement conducteurs ne sont pas entourées par l'enveloppe. Un élément électriquement conducteur comprend une portion centrale et deux extrémités, chacune des extrémités terminant la portion centrale. L'enveloppe surmoule la portion centrale mais pas les deux extrémités.

Grâce aux caractéristiques de l'invention, l'interconnecteur permet de réaliser, de manière déportée, les connexions électriques entre le module de puissance et la carte électronique annexe. L'interconnecteur rassemble la grille de connexion en son sein. Le nombre et le cheminement des éléments électriquement conducteurs, ainsi que l'emplacement des plages et bornes de connexion peuvent être adaptés à la configuration du module de puissance et celle de la carte électronique. Cela permet de considérer un module de puissance standardisé et de procéder aux adaptations nécessaires des connexions au niveau de l'interconnecteur.

Selon une caractéristique optionnelle de l'invention, les plages de connexion sont parallèles entre elles. Cela permet de les connecter à des faces de connexion du module de puissance qui sont dans un plan de la surface supérieure du module de puissance.

Selon une caractéristique optionnelle de l'invention, la au moins une piste électriquement conductrice comprend une première partie ayant une forme plane et une deuxième partie comportant la plage de connexion, la première partie s'étendant selon un axe sécant, préférentiellement perpendiculaire, à une surface de la plage de connexion. Une telle forme de piste électriquement conductrice permet de connecter d'une part la plage de connexion à une zone de connexion du module de puissance et d'autre part la première partie à un dispositif annexe, par exemple la carte électronique pour les signaux, par exemple les conducteurs de puissance, notamment de type busbars, de manière déportée.

L'invention porte aussi sur un ensemble de puissance comprenant un tel interconnecteur, et au moins un module de puissance comprenant :
- Une carte de puissance comprenant un substrat du module de puissance, deux portions de puissance disposées sur le substrat,
- Une carte de signal montée sur la carte de puissance,
- Des plots de connexion électriquement conducteurs, chaque plot de connexion comprenant une première face et une deuxième face parallèle à la première face, la première face étant connectée à une parmi les portions de puissance et la carte de signal,
- Un boîtier enrobant la carte de puissance, la carte de signal et les plots de connexion,
la deuxième face des plots de connexion étant affleurante à une surface supérieure du boîtier et, pour chaque plot de connexion, une plage de connexion de l'interconnecteur étant électriquement connectée à une deuxième face d'un des plots de connexion. Cela signifie que les plots de connexion s'étendent, préférentiellement perpendiculairement au plan du substrat, depuis une portion de puissance ou la carte de signal jusqu'à la surface supérieure du boîtier. Autrement dit, la deuxième face est apparente au niveau de la surface supérieure du boîtier, et préférentiellement parallèle au plan du substrat. La deuxième face se situe dans un plan parallèle au plan de la zone de surface supérieure sur laquelle elle débouche, ce plan étant préférentiellement sensiblement coplanaire avec le plan de ladite zone de surface. Les plages de connexion sont parallèles aux deuxièmes faces, de sorte à assurer une connexion plane.

On comprend ainsi qu'un tel module de puissance contient les portions de puissance et la carte de signal, chacune présentant des zones de connexion au niveau de la deuxième face des plots de connexion qui leur sont associés. Pour chaque plot de connexion, la deuxième face est située au niveau de la surface supérieure du boîtier. Ainsi, tous les éléments du module de puissance forment un premier étage et sont enrobés dans le boîtier. Les plots de connexion permettent d'assurer la connexion des portions de puissance et de la carte de signal. Ils font le lien électrique entre le premier étage et la surface supérieure du boîtier.

Le module de puissance n'inclut pas la grille de connexion dans son boîtier. La grille de connexion est contenue dans l'interconnecteur. L'interconnecteur constitue le deuxième étage et fait le lien électrique entre le premier étage et le dispositif annexe. La grille de connexion de l'interconnecteur peut être connectée aux portions de puissance et à la carte de signal par le biais des plots de connexion dont la deuxième face affleure la surface supérieure du boîtier. La connexion aux portions de puissance et à la carte de signal est ainsi déportée en surface supérieure du boîtier. Le déport de la grille de connexion en dehors du module de puissance permet d'une part d'offrir une large variété de positionnements possibles des éléments dans le module puisqu'il ne faut plus tenir compte du routage des éléments conducteurs au sein du boîtier, et d'autre part de faciliter la fabrication d'un tel module de puissance en rendant l'étape d'injection de résine plus simple et moins coûteuse.

Le principe de l'invention repose ainsi sur la séparation de la grille de connexion du module de puissance et le déport des connexions électriques des portions de puissance et de la carte de signal au niveau de la surface supérieure du boîtier du module de puissance. En externalisant la grille de connexion, cela autorise une standardisation du module. Les éléments conducteurs ont pour rôle de former les contacts du module de puissance vers les entrées/sorties des dispositifs électroniques du client. Comme le module de puissance n'inclut pas la grille de connexion, il en ressort qu'un même module de puissance peut être utilisé pour différents dispositifs électroniques. Seul l'interconnecteur doit être adapté aux spécificités du dispositif électronique auquel le module de puissance doit être connecté. Il en résulte une plus grande modularité des ensembles de puissance.

Il faut souligner que le module de puissance de l'ensemble de puissance de l'invention est un module sans grille de connexion. Une fois connectée au module de puissance, la grille de connexion forme le deuxième étage qui se trouve donc déporté au-dessus du module de puissance. On comprend ainsi qu'étant à l'extérieur du module de puissance, la grille de connexion n'impacte pas le positionnement des plots de connexion. Le module de puissance de l'invention offre ainsi plus d'espace dans le plan du substrat pour ordonner les groupes de connexion (portions de puissance et carte de signal) selon un axe X du plan du substrat et pouvoir positionner un plus grand nombre de transistors selon un axe Y du plan du substrat, perpendiculaire à l'axe X.

Selon une caractéristique optionnelle de l'invention, la deuxième face d'au moins un plot de connexion, préférentiellement de chacun des plots de connexion connecté à la carte de signal, présente un degré de liberté en translation selon un axe perpendiculaire au plan du substrat. Autrement dit, un tel plot de connexion présente une élasticité selon une direction perpendiculaire aux faces du plot de connexion. Cela permet de maintenir les deux faces du plot de connexion parallèles entre elles lorsque le plot de connexion est comprimé selon cette direction. On parle aussi de plot déformable.

Selon une caractéristique optionnelle de l'invention, la deuxième face d'au moins un plot de connexion, préférentiellement de chacun des plots de connexion connecté aux portions de puissance, est à distance constante de la première face dudit plot de connexion. Un tel plot de connexion est aussi appelé pilier rigide. Le pilier rigide ne se déforme pas. Il est avantageusement de forme cylindrique mais peut prendre la forme de tout autre polyèdre.

Selon une caractéristique optionnelle de l'invention, la première face d'au moins un plot de connexion est connectée à la carte de signal par un moyen pris parmi le collage électriquement conducteur, le soudage ou le brasage. En ayant recours à de tels moyens électriquement conducteurs, on assure la connexion électrique des plots de connexion à la portion de puissance ou la carte de signal à laquelle il est associé.

L'invention concerne aussi un convertisseur de courant, notamment DC/DC ou AC/DC, comprenant un ensemble de puissance tel que décrit précédemment, une carte électronique comprenant des broches de connexion électriquement connectées aux bornes de connexion de l'interconnecteur de l'ensemble de puissance, et un dissipateur thermique sur lequel le au moins un ensemble de puissance est disposé.

Grâce à l'ensemble de puissance de l'invention, la grille de connexion est séparée du module de puissance. La grille de connexion est intégrée dans l'interconnecteur qui gère les entrées et sorties client. Une telle combinaison permet à la fois de rendre plus d'espace disponible dans le plan XY du substrat pour procéder au positionnement des transistors et apporter plus de possibilités de cheminements des lignes de connexion. En outre, la séparation des lignes de puissance et de signal d'une part dans le module de puissance et des éléments conducteurs d'autre part dans l'interconnecteur permet de considérer un seul type de module de puissance pour diverses applications. L'adaptation des connexions d'entrée et sortie vers l'interface client se fait au niveau de l'interconnecteur. Il en résulte que l'invention offre un module de puissance compact et standardisé quelle que soit l'application ultérieure envisagée.

L'invention porte aussi sur un véhicule automobile comprenant un tel convertisseur de puissance.

D'autres caractéristiques et avantages de l'invention apparaîtront encore au travers de la description qui suit d'une part, et de plusieurs exemples de réalisation donnés à titre indicatif et non limitatif en référence aux dessins schématiques annexés d'autre part, sur lesquels :
[fig 1] représente une vue d'un exemple de module de puissance auquel un interconnecteur selon l'invention peut se connecter ;
[fig 2] représente une vue extérieure du boîtier du module de puissance de la figure 1;
[fig 3] représente une vue d'un module de puissance connecté à une grille de connexion de l'interconnecteur de l'invention ;
[fig 4] représente une vue de l'ensemble de puissance comprenant un module de puissance et l'interconnecteur de l'invention.

Les caractéristiques, variantes et les différentes formes de réalisation de l'invention, telles qu'elles ont été décrites ou telles qu'elles vont être présentées dans la description détaillée qui va suivre, peuvent être associées les unes avec les autres, selon diverses combinaisons, dans la mesure où elles ne sont pas incompatibles ou exclusives les unes par rapport aux autres. On pourra notamment imaginer des variantes de l'invention ne comprenant qu'une sélection de caractéristiques décrites par la suite de manière isolée des autres caractéristiques décrites, si cette sélection de caractéristiques est suffisante pour conférer un avantage technique et/ou pour différencier l'invention par rapport à l'état de la technique antérieur.

Par souci de clarté, les mêmes éléments sont désignés par les mêmes références aux différentes figures.

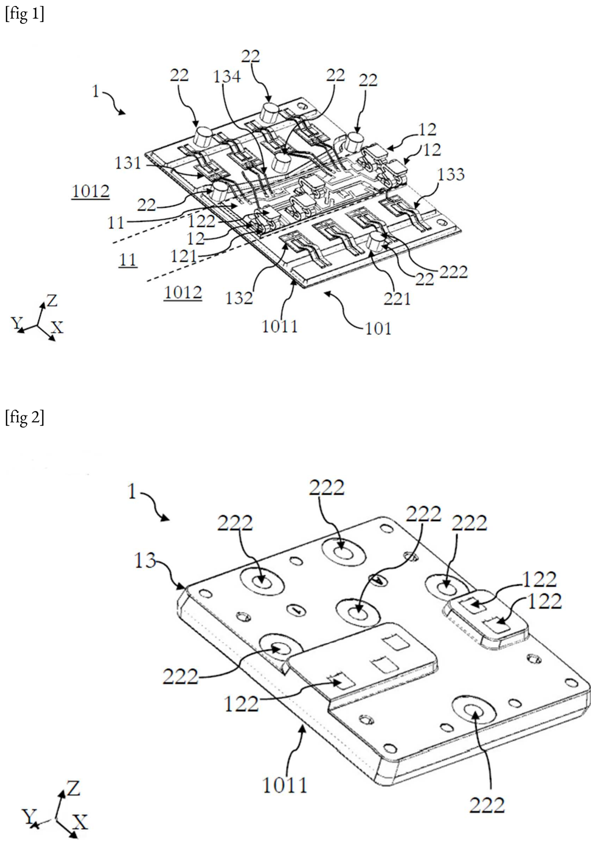

La figure 1 représente une vue d'un exemple de module de puissance 1 auquel un interconnecteur selon l'invention peut se connecter.

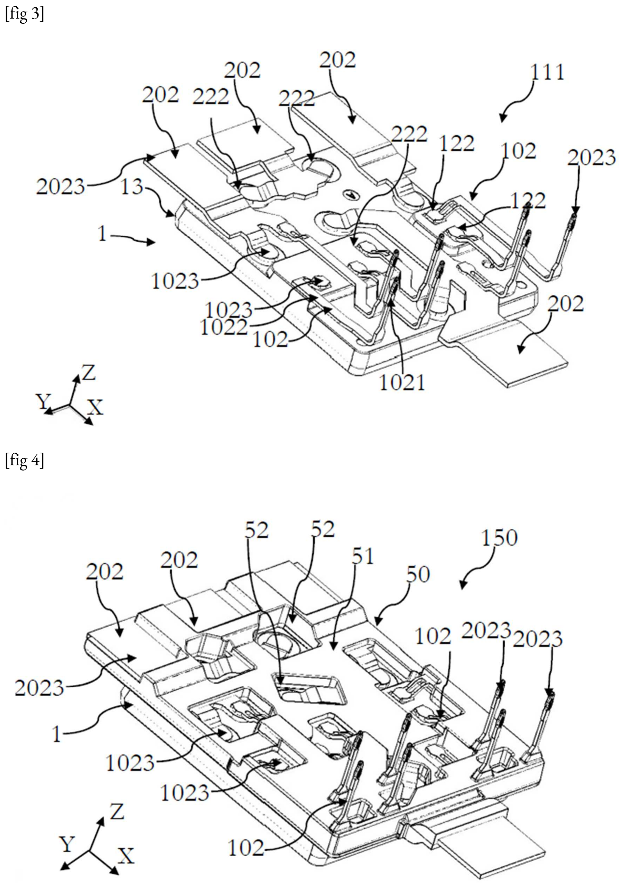

L'invention porte spécifiquement sur un interconnecteur 50 (visible sur la figure 4) destiné à être électriquement connecté à un module de puissance, par exemple le module de puissance 1 illustré à la figure 1 et à une carte électronique et/ou à des conducteurs de puissance de type busbars. Selon l'invention, l'interconnecteur 50 comprend une grille de connexion 111 comprenant des éléments électriquement conducteurs 102, 202 parmi lesquels au moins une piste électriquement conductrice 102 de signal et au moins un conducteur 202 de puissance. Chacun des éléments conducteurs comprend, à une première extrémité, une plage de connexion 1023 destinée à être électriquement connectée au module de puissance 1 et, à une deuxième extrémité, une borne de connexion 2023 destinée à être électriquement connectée à la carte électronique ou aux conducteurs de puissance. L'interconnecteur 50 comprend en outre une enveloppe 51 partiellement surmoulée autour des éléments électriquement conducteurs 102, 202. Les plages de connexion 1023 et les bornes de connexion 2023 sont disposées à l'extérieur de l'enveloppe 51. En d'autres termes, les plages de connexion 1023 et les bornes de connexion 2023 sont libres, c'est-à-dire qu'elles ne sont pas intégrées dans le surmoulage. Cela signifie qu'elles sont accessibles pour réaliser une connexion électrique.

Avant de détailler davantage l'interconnecteur de l'invention, et pour comprendre les intérêts d'un tel interconnecteur, un exemple de module de puissance 1 auquel l'interconnecteur 50 peut se connecter va être décrit. Il faut bien noter que le module de puissance est un exemple d'application. Le principe de l'invention s'applique de façon similaire pour d'autres formes et composants de module de puissance.

Le module de puissance 1 est destiné à être connecté à une grille de connexion 111. Le module de puissance 1 comprend une carte de puissance 101 comprenant un substrat 1011 du module de puissance, deux portions de puissance 1012 disposées sur le substrat 1011. Le substrat 1011 forme le support principal du module de puissance 1. Le module de puissance 1 comprend une carte de signal 11 montée sur la carte de puissance 101. La carte de signal 11 est connectée électriquement à la carte de puissance 101.

Le module de puissance 1 comprend des plots de connexion 12, 22 électriquement conducteurs. Chaque plot de connexion 12, 22 comprend une première face 121, 221 et une deuxième face 122, 222, parallèle à la première face 121, 221. La première face 121, 221 est connectée à une parmi les portions de puissance 1012 et la carte de signal 11. La deuxième face 122, 222 est destinée à être connectée électriquement à la grille de connexion 111. Le substrat 1011 s'étendant dans un plan XY, les plots de connexion 122, 222 s'étendent selon un axe Z perpendiculaire au plan XY du substrat 1011.

Le module de puissance 1 comprend un boîtier 13 (visible sur la figure 2) enrobant la carte de puissance 101, la carte de signal 11 et les plots de connexion 12, 22. Suivant un mode de réalisation, le matériau d'enrobage du boîtier 13 est une résine époxy.

La deuxième face 122, 222 des plots de connexion 12, 22 est affleurante à une surface supérieure du boîtier 13. En d'autres termes, la deuxième face 122, 222 se situe dans le plan d'une surface supérieure du boîtier 13 du module de puissance 1. La deuxième face 122, 222 est libre de sorte à permettre une connexion électrique avec la grille de connexion.

Il faut bien noter qu'un tel module de puissance 1 n'inclut pas la grille de connexion dans le boîtier. Il offre ainsi une connexion aux portions de puissance 1012 et à la carte de signal 11 qui est déportée en surface supérieure du boîtier 13. Cet arrangement est particulièrement intéressant puisque le module de puissance n'inclut pas la grille de connexion 111 dans son boîtier 13. La grille de connexion fait partie de l'interconnecteur de l'invention qui sera décrit ci-après. La connexion entre la grille de connexion 111 et la carte de puissance 101 se fait par l'intermédiaire des plots de connexion dont la deuxième face est accessible au niveau de la surface supérieure du boîtier. Il n'y a pas de parcours de pistes électriquement conductrices 102 à prévoir dans le boîtier 13. Cela évite de devoir utiliser des moules spécifiques avec un écoulement complexe pour la résine au sein du moule pendant la phase d'injection de résine pour enrober le boîtier.

Un tel module de puissance 1 présente ainsi des connexions de puissance et de signal qui s'étendent selon l'axe Z perpendiculairement au plan XY du substrat.

Selon une variante optionnelle du module de puissance, et tel qu'illustré sur la figure 1, les deux portions de puissance 1012 sont disposées de part et d'autre de la carte de signal 11. Les portions de puissance 1012 sont des bandes planes directement aménagées sur le substrat 1011, parallèles entre elles et coplanaires. Dit autrement, la carte de signal 11 est intercalée entre les deux portions de puissance 1012. La carte de signal 11 est disposée sur la carte de puissance 101 dans une position centrale et les deux portions de puissance 1012 sont disposées sur la carte de puissance 101, chacune étant adjacente à la carte de signal 11. Les deux portions de puissance 1012 et la carte de signal 11 forment ainsi trois bandes parallèles en alternance : une première portion de puissance 1012 disposée de façon contiguë à la carte de signal 11, elle-même disposée de façon contiguë à la deuxième portion de puissance 1012. Cette répartition des portions de puissance autour de la carte de signal formant des bandes parallèles entre elles est symbolisée au moyen de traits pointillés sur la figure 1.

Selon le mode de réalisation illustré sur la figure 1, la carte de puissance comprend des portions de puissance 1012 qui sont soit au potentiel B⁻, soit au potentiel B⁺ soit au potentiel Phase.

La carte de puissance 101 comprend également au moins un transistor de puissance 131, 132. Sur le module de puissance 1 de la figure 1, huit transistors sont représentés : quatre sont sur une première portion de puissance et quatre autres sont sur une deuxième portion de puissance. Bien entendu, on ne sort pas du cadre de l'invention avec un nombre différents de transistors et/ou une disposition différente. Les transistors de puissance permettent la conversion du courant continu et en un système de courant polyphasé et inversement. Il peut s'agir, par exemple, d'un transistor à effet de champ à grille isolée ou MOSFET pour Metal-Oxide-Semiconductor Field-Effect Transistor selon la terminologie anglo-saxonne.

De manière connue, chaque transistor 131, 132 est connecté par des moyens de connexion électrique 133, 134 à une portion de puissance 1012 et la carte de signal 11.

Chaque portion de puissance 1012 est destinée à être connectée électriquement à au moins une piste électriquement conductrice de la grille de connexion par l'intermédiaire d'au moins un plot de connexion 22. Les plots de connexion 22, agencés entre les portions de puissance 1012 et la grille de connexion, ont pour rôle de transmettre la puissance entre les portions de puissance 1012 et les pistes électriquement conductrices de la grille de connexion. Sur la figure 1, les plots de connexion 22 ont une forme cylindrique. Cette représentation n'est nullement limitative. Les plots de connexion peuvent être de différentes formes comme des cubes, des parallélépipèdes ou tout autre forme volumique.

La carte de signal 11 est connectée électriquement à la carte de puissance 101. La carte de signal 11 est reliée aux différents transistors de puissance de la carte de puissance 101 par les moyens de connexion 134 afin d'envoyer les signaux permettant de commander les transistors de puissance.

Sur la carte de signal 11 sont connectés électriquement des plots de connexion 12. Ces plots de connexion 12 permettent de faire transiter des signaux électriques de commande entre la carte de signal 11 et l'extérieur du module de puissance 1.

La disposition des deux portions de puissance 1012 autour de la carte de signal 11 présente l'avantage d'éviter les croisements de lignes de puissance au-dessus du substrat.

Dans un tel module, les connexions de puissance et de signal s'étendant vers le haut à partir du substrat de puissance, c'est-à-dire depuis le substrat et perpendiculairement au plan du substrat, possiblement assemblé en trois groupes et moulé sans grille de connexion avec la surface supérieure à l'extérieur du boîtier du module de puissance. Un premier groupe forme un contact de sortie sur un côté du module via une portion de puissance 1012 (par exemple la phase), un deuxième groupe forme un contact de signal au milieu du substrat via la carte de signal, un troisième groupe forme tous les contacts d'entrée et de sortie de puissance d'un deuxième côté (par exemple B+, B-, phase).

La conception du module de puissance est simplifiée puisqu'elle est non impactée par des interfaces spécifiques et peut être la même entre toutes les applications pour les onduleurs de traction, avec une réduction significative des coûts de développement.

On comprend de ce qui précède que l'interconnecteur, objet de l'invention, est destiné à coopérer avec un tel module de puissance. Comme cela sera présenté ci-dessous, un interconnecteur 50 comprenant la grille de connexion autorise une conception simplifiée d'un tel module de puissance et permet une adaptation facilitée de l'interface entre le module de puissance et la carte électronique ou toute autre interface client. Il en résulte que l'invention permet d'adapter l'interconnecteur aux besoins de connexion et offre ainsi la possibilité d'un module de puissance compact et standardisé quelle que soit l'application ultérieure envisagée. En d'autres termes, l'interconnecteur absorbe toutes les variantes des interfaces client. Il autorise une grande modularité dans l'application d'un module de puissance standardisé.

Dans une variante du module de puissance 1, la deuxième face 122 d'au moins un plot de connexion 12 connecté à la carte de signal 11 présente un degré de liberté en translation selon un axe Z perpendiculaire au plan XY du substrat 1011. La première face 121 et la deuxième face 122 sont reliées par des moyens de déformation élastique. Les moyens de déformation élastique des plots de connexion 12 sont agencés de façon à assurer le parallélisme des première et deuxième faces 121, 122 lors d'une déformation de ces moyens selon une direction Z perpendiculaire aux surfaces des première et deuxième faces 121, 122.

Les plots de connexion 12 sont élastiquement déformables. Ces plots présentent donc une certaine élasticité qui leur permet de rattraper le jeu en hauteur (selon l'axe Z) dans le positionnement relatif du module de puissance et de l'interconnecteur.

La première face 121 d'au moins un plot de connexion 12 est connectée électriquement à la carte de signal 11. La connexion est réalisée par un moyen électriquement conducteur comme le soudage, par exemple laser ou ultrason, le brasage, le collage électriquement conducteur ou tout autre moyen équivalent.

Dans une variante du module de puissance 1, la deuxième face 222 d'au moins un plot de connexion 22 connecté aux portions de puissance 1012 est à distance constante de la première face 221 dudit plot de connexion 222. Autrement dit, le plot de connexion 22 est un pilier rigide.

La figure 2 représente une vue extérieure du boîtier du module de puissance de la figure 1. Cette vue permet de mettre en valeur le substrat 1011 qui forme le support du module de puissance 1 et l'encapsulation par le boîtier 13 de l'ensemble des éléments constituant le module de puissance. On voit également que les deuxièmes faces 122, 222 sont affleurantes à la surface supérieure du boîtier 13. On voit ainsi qu'il suffit de disposer l'interconnecteur 50 de l'invention sur la surface supérieure du boîtier 13 pour permettre la connexion des entrées/sorties du module de puissance. L'interconnecteur 50 est destiné à coopérer avec tout module de puissance comprenant des deuxièmes faces 122, 222 sur la surface supérieure du boîtier 13 du module de puissance, les deuxièmes faces constituant les points de connexion électrique entre la grille de connexion de l'interconnecteur et les portions de puissance et la carte de signal du module de puissance.

La figure 3 représente une vue d'un module de puissance connecté à une grille de connexion 111 de l'interconnecteur 50 de l'invention. Sur cette vue et afin de bien faire apparaître les connexions électriques au niveau des deuxièmes faces 122, 222, l'enveloppe 51 n'est pas représentée. La grille de connexion 111 comprend les éléments électriquement conducteurs 102, 202. Nous voyons ici deux types d'éléments conducteurs. Un type d'éléments conducteurs est formé par les pistes électriquement conductrices 102 de signal, destinées à être connectées à la carte électronique pour le contrôle du module. La carte électronique peut être de type PCB. Et un autre type d'éléments conducteurs est formé par les conducteurs 202 de puissance destinés à être connectées aux conducteurs de puissance, notamment des busbars, notamment parcourus AC ou DC pour les connexions en puissance du module

Chacun des éléments conducteurs 102, 202 présente deux extrémités. A une première extrémité se trouve une plage de connexion 1023. La plage de connexion est électriquement connectée au module de puissance 1. Plus précisément, la plage de connexion 1023 d'un élément conducteur est connectée à une deuxième face d'un plot de connexion. A une deuxième extrémité se trouve une borne de connexion 2023 destinée à être électriquement connectée à la carte électronique, typiquement à une broche de connexion d'un dispositif électronique constituant l'interface client.

Comme cela est visible sur la figure 2, la surface supérieure du module de puissance 1 expose les deuxièmes faces 122, 222 des plots de connexions. Ces deuxièmes faces affleurant la surface supérieure du boîtier 13 sont le point de connexion entre la grille de connexion et les portions de puissance 1012 et la carte de signal 11.

L'extrémité 1023 (la plage de connexion) d'une piste électriquement conductrice 102 peut alors être connectée à une deuxième face d'un plot de connexion par soudage au laser ou par ultrason.

Selon une variante possible représentée à la figure 3 à titre d'exemple, au moins une piste électriquement conductrice 102 comprend une première partie 1021 ayant une forme plane et une deuxième partie 1022 comportant la plage de connexion 1023. La deuxième partie peut avoir une forme tridimensionnelle. La première partie 1021 s'étend selon un axe sécant, préférentiellement perpendiculaire, à une surface de la plage de connexion 1023.

La plage de connexion 1023 de la deuxième partie 1022 de la piste électriquement conductrice 102 est affleurante à une surface extérieure du boîtier 13. C'est la plage de connexion 1023 qui est soudée à la deuxième face qui lui est associée. Il s'agit ici d'un exemple de réalisation et l'invention ne se limite nullement à cette configuration de pistes 102. Dans le cadre de l'invention, d'autres formes de pistes 102 sont envisageables.

De façon similaire aux pistes électriquement conductrices 102, la grille de connexion comprend aussi des conducteurs 202 associés aux portions de puissance 1012. Les conducteurs 202 ont également chacun une plage de connexion 1023 et une borne de connexion 2023. La plage de connexion 1023 est destinée à être en contact, et soudée, à une deuxième face 222 du module de puissance. La borne de connexion 2023 est destinée à être connectée électriquement au dispositif annexe (interface client).

Il ressort de la description de l'invention que l'interconnecteur 50 offre une grande adaptabilité des connexions entre le module de puissance et l'interface client. Il suffit d'adapter les cheminements de ses pistes électriquement conductrices 102 et de ses conducteurs 202 pour connecter électriquement les portions de puissance et la carte de signal du module de puissance aux broches de connexion de l'interface client. Un tel interconnecteur 50 constitue l'ajustement entre un module de puissance pouvant être standardisé et les broches de connexion du dispositif client. L'interconnecteur 50 présente l'avantage de pouvoir être facilement adapté au positionnement des broches de connexion. Il suffit de modifier les bornes de connexion 2023, et éventuellement le cheminement de éléments conducteurs 102, 202, et de surmouler les éléments conducteurs pour obtenir un interconnecteur compatible du dispositif client.

La figure 4 représente une vue de l'ensemble de puissance 150 comprenant un module de puissance 1 et l'interconnecteur 50 de l'invention. L'ensemble de puissance 150 comprend un interconnecteur 50 tel que décrit précédemment et un module de puissance également décrit précédemment.

Dans l'ensemble de puissance 150, la deuxième face 122, 222 des plots de connexion 12, 22 est affleurante à une surface supérieure du boîtier 13 et, pour chaque plot de connexion 12, 22, une plage de connexion 1023 de l'interconnecteur 50 est électriquement connectée à une deuxième face d'un des plots de connexion 12, 22.

Dans une variante du module de puissance décrite précédemment, les plots de connexion 12 présentent un degré de liberté en translation selon l'axe Z entre ses deux faces 121, 122.

En d'autres termes, les plots de connexion 12 sont élastiquement déformables. Ces plots présentent donc une certaine élasticité qui leur permet de rattraper le jeu en hauteur selon l'axe Z lorsqu'une force leur est appliquée. Cela signifie que l'assemblage de l'interconnecteur sur le module de puissance permet un rattrapage en hauteur au niveau des plots de connexion 12 pour garantir la connexion dans l'interconnecteur 50. Grâce à l'élasticité des plots de connexion 12, même en présence de défaut de positionnement, la connexion entre les plages de connexion 1023 et les deuxièmes faces 102 est garantie.

Tel que cela est visible sur la figure 4, l'interconnecteur 50 est ajouré. Les ajourements 52 (ou ouvertures traversantes 52) correspondent aux points d'accès des plages de connexion 1013 des éléments conducteurs. Une fois l'interconnecteur 50 disposé sur la surface supérieure du boîter 13 du module de puissance, les ajourements 52 deviennent des cavités puisque la face inférieure de l'interconnecteur épouse la forme de la surface supérieure du boîtier 13 de sorte à former un ensemble de puissance présentant une surface supérieure sensiblement plane.

Selon la configuration du dispositif de l'interface client, il se peut que des pièces métalliques, par exemple un support de carte électronique, soient positionnées à proximité de l'interconnecteur. Une telle configuration présente un risque pour l'isolation électrique, en particulier pour la distance d'isolation électrique qui doit être supérieure à une distance prédéfinie, par exemple supérieure à 4 mm (millimètres) pour une tension de 800 V DC.

Dans une variante de l'invention, l'interconnecteur 50 peut comprendre un matériau isolant (par exemple un gel isolant ou une résine époxy) dans au moins une, et préférentiellement chacune, des cavités 52 façonnées dans l'interconnecteur, afin de garantir la distance d'isolation requise et respecter les règles d'isolation.

L'invention porte aussi sur un convertisseur de courant, notamment DC/DC ou AC/DC, comprenant un ensemble de puissance 150 tel que décrit ci-dessus, une carte électronique comprenant des broches de connexion électriquement connectées aux bornes de connexion de l'interconnecteur 50 de l'ensemble de puissance 150, et un dissipateur thermique sur lequel le au moins un ensemble de puissance 150 est disposé. Le dissipateur thermique assure l'évacuation de la chaleur produite par le ou les modules de puissance de l'ensemble de puissance 150.

Dans une variante, le convertisseur de courant peut comprendre un interconnecteur, par module de puissance ou par un groupe d'au moins deux modules de puissance.

Bien sûr, l'invention n'est pas limitée aux exemples qui viennent d'être décrits et de nombreux aménagements peuvent être apportés à ces exemples sans sortir du cadre de l'invention. Notamment les caractéristiques de différentes variantes de réalisation de l'invention peuvent être combinées pour réaliser l'invention, dans la mesure où ces variantes ne sont pas incompatibles entre elles.

## Revendications

1. Interconnecteur (50) destiné à être électriquement connecté à un module de puissance (1) et à une carte électronique et/ou a des connecteurs de puissance, **caractérisé en ce qu'**il comprend :
- une grille de connexion (111) comprenant des éléments électriquement conducteurs (102, 202) parmi lesquels au moins une piste électriquement conductrice (102) de signal et au moins un conducteur (202) de puissance, chacun des éléments conducteurs comprenant, à une première extrémité, une plage de connexion (1023) destinée à être électriquement connectée au module de puissance (1) et, à une deuxième extrémité, une borne de connexion (2023) destinée à être électriquement connectée à la carte électronique et/ou aux conducteurs de puissance,
- une enveloppe (51) partiellement surmoulée autour des éléments électriquement conducteurs (102, 202), les plage de connexion (1023) et les bornes de connexion (2023) étant disposées à l'extérieur de l'enveloppe (51).

2. Interconnecteur (50) selon la revendication 1, dans lequel les plages de connexion (1023) sont parallèles entre elles.

3. Interconnecteur (50) selon la revendication 1 ou 2, dans lequel la au moins une piste électriquement conductrice (102) comprend une première partie (1021) ayant une forme plane et une deuxième partie (1022) comportant la plage de connexion (1023), la première partie (1021) s'étendant selon un axe sécant, préférentiellement perpendiculaire, à une surface de la plage de connexion (1023).

4. Ensemble de puissance (150) comprenant un interconnecteur (50) selon l'une quelconque des revendications 1 à 3, au moins un module de puissance (1) comprenant:
- Une carte de puissance (101) comprenant un substrat (1011) du module de puissance, deux portions de puissance (1012) disposées sur le substrat (1011),
- Une carte de signal (11) montée sur la carte de puissance (101),
- Des plots de connexion (12, 22) électriquement conducteurs, chaque plot de connexion (12, 22) comprenant une première face (121, 221) et une deuxième face (122, 222) parallèle à la première face (121, 221), la première face (121, 221) étant connectée à une parmi les portions de puissance (1012) et la carte de signal (11),
- Un boîtier (13) enrobant la carte de puissance (101), la carte de signal (11) et les plots de connexion (12, 22),
la deuxième face (122, 222) des plots de connexion (12, 22) étant affleurante à une surface supérieure du boîtier (13) et, pour chaque plot de connexion (12, 22), une plage de connexion (1023) de l'interconnecteur (50) étant électriquement connectée à une deuxième face d'un des plots de connexion (12, 22).

5. Ensemble de puissance (150) selon la revendication 4, dans lequel les deux portions de puissance (1012) sont disposées de part et d'autre de la carte de signal (11).

6. Ensemble de puissance (150) selon la revendication 4 ou 5, dans lequel la deuxième face (122) d'au moins un plot de connexion (12), préférentiellement de chacun des plots de connexion connecté à la carte de signal (11), présente un degré de liberté en translation selon un axe (Z) perpendiculaire au plan (XY) du substrat (1011).

7. Ensemble de puissance (150) selon l'une quelconque des revendications 4 à 6, dans lequel la deuxième face (222) d'au moins un plot de connexion (22), préférentiellement de chacun des plots de connexion connecté aux portions de puissance (1012), est à distance constante de la première face (221) dudit plot de connexion (222).

8. Ensemble de puissance (150) selon l'une quelconque des revendications 4 à 7, dans lequel la première face (121) d'au moins un plot de connexion (12) est connectée à la carte de signal (11) par un moyen pris parmi le collage électriquement conducteur, le soudage ou le brasage.

9. Convertisseur de courant, notamment DC/DC ou AC/DC, comprenant un ensemble de puissance (150) selon l'une quelconque des revendications 4 à 8, une carte électronique comprenant des broches de connexion électriquement connectées aux bornes de connexion de l'interconnecteur (50) de l'ensemble de puissance (150), et un dissipateur thermique sur lequel le au moins un ensemble de puissance est disposé.

10. Véhicule automobile comprenant un convertisseur de courant selon l'une quelconque des revendications 8 à 9.
